# EUROPEAN PATENT SPECIFICATION

(11) **EP 1 788 854 B1**
(45) Date of publication and mention of the grant of the patent: **14.01.2015**
(21) Application number: 06122417.6
(22) Date of filing: 17.10.2006
(51) Int. Cl.: H05K 5/00

(54) **Electronic device comprising a metal housing and a cosmetic envelope**
Elektonische Vorrichtung bestehend aus einem metallischen Gehäuse und einer kosmetischen Hülle
Dispositif électronique constitué d'un boîtier métallique et d'une envelope cosmétique

(30) Priority: 21.11.2005 EP 05111047
(43) Date of publication of application: 23.05.2007
(73) Proprietor: Thomson Licensing, Inc., 92100 Boulogne-Billancourt (FR)
(72) Inventor: Knight, Simon, RCT CF39 8UA (GB)
(74) Representative: Perrot, Sébastien

(56) References cited:
- WO-A1-03/079741
- JP-A- 2005 294 357
- US-A- 5 508 887
- US-B1- 6 194 653

## Description

The present invention relates to an electronic device comprising a housing and a cosmetic envelope.

An electronic device such as a set-top box is a set of electronic components, such as integrated circuits, a processor, memories, fans, etc... It generally comprises a metal housing that includes and protects all the electronic components. Externally, the housing comprises the gear necessary to drive the device; e.g. buttons, plugs, displays.

In current generations of such an electronic device, plastic cosmetic box, or casing, has been added around the housing. The cosmetic box is generally made of several pieces of plastic to cover each side of the metal housing. Each piece of plastic is fixed independently to the housing with clips and/or screws.

For example a set-top box is surrounded by a plastic box made of several panels to cover most sides of the set-top box. And it is fixed to the metal box through several screws on each side of the metal box.

With the current design, the access to the housing requires the dismantling of the plastic box. For example in a repair centre, the operator needs to remove all the plastic pieces before accessing the housing. Disassembling and reassembling the device cost time. And it costs additional time when the operator loses a screw, or breaks a piece of plastic. It is therefore desirable to simplify the disassembling and reassembling of the electronic device when it is being serviced.

US6545874B1 deals with a compact computer arrangement in which components are disposed within an exterior computer housing maximizing space efficiency while remaining accessible.

US2003/0233667 deals with a method and an apparatus for implementing a scaled upgrading of an upgradeable set-top box.

US4941841 deals with an adapter provided for a removable information storage device in an information storage system.

US6301103B1 deals with an external casing having a modular design for encasing a variety of hardware peripherals within an interior compartment.

US2005/0094380A1 deals with electrical equipment in which a chassis mounting thereto electronic parts can be simply mounted on a bottom of a cabinet without using screws and which can be simply disassembled.

The present invention concerns an electronic device comprising a housing and a cosmetic envelope, where the envelope is easily assembled to the housing.

To this end, the invention relates to an electronic device comprising a housing element for lodging a set of electronic components, comprising a top panel, a bottom panel, a front panel, a back panel, side panels, a cosmetic envelope surrounding the housingand fixed to the housing, the envelope comprising means for being assembled to form a single piece before it is fastened to the housing, and clipping means for fastening the envelope to the housing.

Having the complete housing with all electronic components in place means that the electronic unit can be fully tested before assembling the outer envelope. This helps reduce the likelihood of marking the cosmetic faces.

Preferably, the clipping means comprises at least a slot arrangement on the bottom panel of the housing for mounting at least a clip of the envelope, and at least a slot arrangement on the top panel of the housing for mounting a at least clip of the envelope.

According to an embodiment, the housing comprises a screw hole, the envelope comprises a screw hole, and said screw holes are facing each other when the envelope has been clipped to the housing.

Preferably, the envelope comprises a top panel, a bottom panel, a front panel, a back panel, side panels so that said envelope surrounds only the front panel, the top panel, and the side panels of the housing.

According to an embodiment, the electronic device is a set-top box.
- The invention also concerns a cosmetic envelope intending to surround a housing element for lodging a set of electronic components and to be fixed to the housing. The envelope comprises clipping means for being fastened to the housing, and means for being assembled to form a single piece before it is fastened to the housing.

The invention also concerns a method for fixing an envelope that is constituted of a single piece to a housing element lodging a set of electronic components. The method comprises the following steps of sliding the housing element inside the envelope, clipping on the envelope to the housing; and screwing the envelope to the housing.

The invention also concerns a method for removing an envelope that is constituted of a single piece from a housing element lodging a set of electronic components. The method comprises the steps of unscrewing the envelope from the housing; unclipping on the envelope from the housing; and sliding the housing element outside the envelope.

The invention will be better understood and illustrated by means of the following embodiment and which will be described, in no way restrictive, with reference to the appended figures among which:
- Figure 1 is a view of the electronic device compliant with the embodiment;
- Figure 2 is a bottom view of the envelope and the housing compliant with the embodiment;
- Figure 3 is a top view of the envelope and the housing compliant with the embodiment;
- Figure 4 is a bottom view of the envelope.

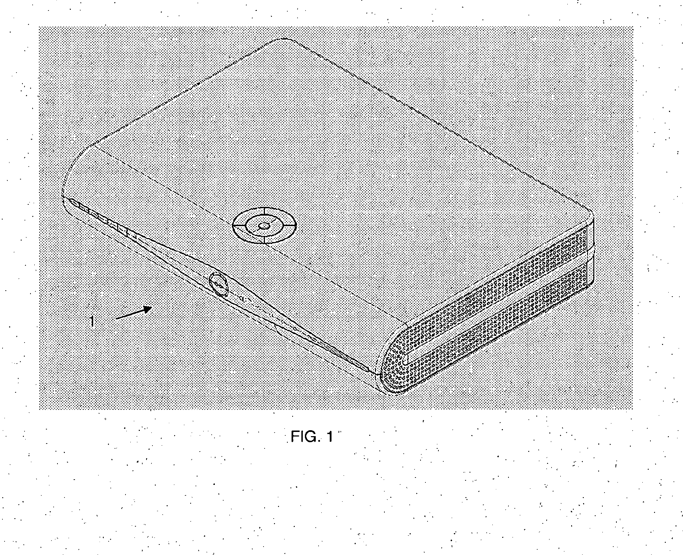

Figure 1 is a top view of a preferred embodiment of an electronic device (1). It is a set-top box television receiver. In a preferred embodiment the electronic device (1) is a movable object: it can be easily moved from one place to another place. It is not fixed to another device.

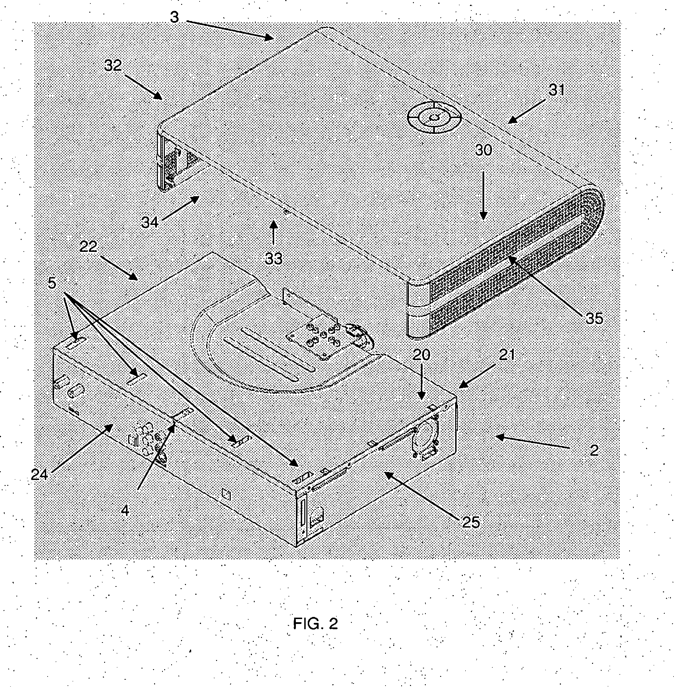

The electronic device (1) comprises a housing (2) preferably made of metal and an envelope (3), as represented in figure 2.

The housing (2) is a parallelepiped box that comprises the electronic equipments (not represented) of the electronic device, such as a hard drive, fans, a processor, and integrated circuits, etc... It securely protects the electronic equipments. The housing (2) is made of metal to ensure electromagnetic compatibility. It could be made of another material than metal, e.g. plastic, if the other material ensures electromagnetic compatibility, or if there is no such requirement.

The envelope (3) is preferably made of plastic to achieve the required design. The envelope is a single unit that is fixed to the housing.

In an embodiment, the envelope is made of several plastic elements that are attached together. When all the elements are put together to form a single set, the envelope can then be fixed to the housing.

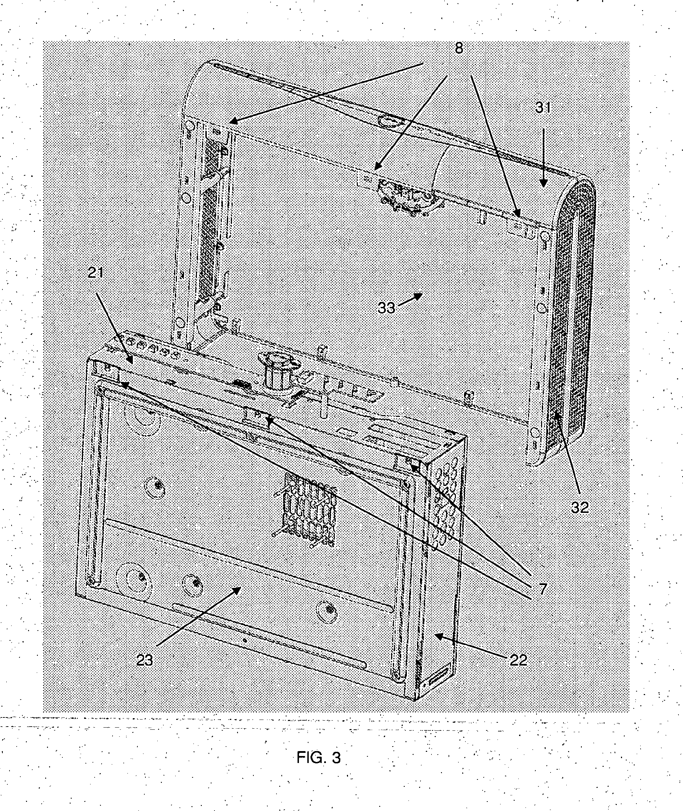

As indicated on figures 2 and 3, the housing (2) comprises a top panel (20), a bottom panel (23), a front panel (21), a back panel (24), a left panel (25) and a right panel (22). The envelope (3) comprises a top panel (30), a bottom panel (33), a front panel (31), a back panel (34), a left panel (35) and a right panel (32).

In a preferred embodiment, the envelope (3) preferably surrounds only the front panel (21), the top panel (20), the left panel (25) and the right panel (22) of the housing (2). The envelope does not cover the bottom panel and the back panel of the housing. As the primary purpose of the plastic envelope is aesthetic, it is not necessary to cover these panels; the bottom panel and the back panel of the housing are not readily visible to the user when the device is placed in its working environment.

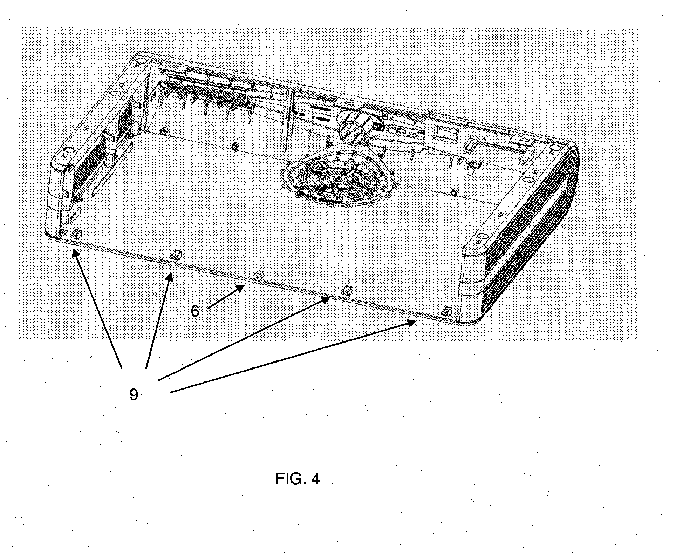

The envelope comprises clipping means. In a preferred embodiment, the envelope is fixed to the housing with several clips as indicated on figures 2, 3 and 4. This permits to hold together the envelope and the housing.

The envelope comprises three clips (8) on the bottom panel (33).

The housing comprises three slot arrangements (7) in order to be attached to the clips of the envelope.

The envelope also comprises four clips (9) under the top panel (30). And the housing comprises four slots (5) for mounting the four clips (9).

In another embodiment, the envelope is fixed to the housing with a rail system (not represented). The housing slides into the envelope between two rails located inside the envelope on the right panel and on the left panel, until the front panel of the housing rests against the internal side of the front panel of the envelope.

The envelope comprises a screw hole (6) and the housing comprises a screw hole (4). When the envelope is clipped on the housing, the screw holes are facing each other.

Only one screw is required to fix the envelope to the housing. This is mainly used for safety, because the envelope and the housing are already and sufficiently attached with the clipping means. If the latching means are broken, the screw permits to keep the envelope attached to the housing.

Moreover, when the envelope is made of several plastic elements that are attached together, the screw permits to secure the fastening of all plastic elements together when the envelope is fixed to the housing.

With the clip system and the single screw, the envelope is then easily attached and detached to/from the housing.

The method to attach the envelope to the housing is as follows. First the housing slides into the envelope from the back panel towards the front panel of the envelope. Then the envelope is clipped on the housing. Finally, as the screw hole of the envelope faces the screw hole of the housing, the envelope is screwed to the housing.

To detach the envelope from the housing, the first step is to unscrew the envelope from the housing. Then it is necessary to unclip the clips of the envelope from the slots of the housing.

The present embodiment applies to a set-top box. It is also applicable to any device running in the same kind of working environment. It is applicable to any device comprising a housing for lodging a set of electronic gear surrounded by a cosmetic envelope. Some examples of such devices are a video player, a video recorder, an audio unit.

## Claims

1. Electronic device (1) comprising:
- a housing element (2) for lodging a set of electronic components, said housing element (2) comprising a top panel (20), a bottom panel (23), a front panel (21), a back panel (24), side panels (22, 25) and
a cosmetic envelope (3) surrounding said housing element and fixed to said housing element said envelope (3) comprising a top panel (30), a bottom side (33), a front panel (31), a back side (34), side panels (32, 35) such that said envelope surrounds only the top panel (20), the front panel (21), the side panels (22, 25) of the housing element (2), such that the housing element is slidable into the envelope from the back side towards the front panel of the envelope;
- said envelope comprising means for being assembled to form a single piece before it is slided onto the housing, and
- dipping means (5, 7, 8, 9) for fastening said envelope to said housing element.

2. Electronic device according to the preceding claim, **characterized in that** said clipping means comprises:
- at least a slot arrangement (7) on the bottom panel (23) of the housing element for mounting at least a clip (8) of the envelope, and
- at least a slot arrangement (5) on the top panel (20) of the housing element for mounting a at least clip of the envelope.

3. Electronic device according to any of the preceding claims, **characterized in that** the housing comprises a screw hole (4), the envelope comprises a screw hole (6), and said screw holes are facing each other when the envelope has been clipped to the housing element.

4. Electronic device according to any of the preceding claims, **characterized in that** it is a set-top box.

5. Cosmetic envelope (3) for surrounding a housing element (2) for lodging a set of electronic components and to be fixed to said housing element, the housing element comprising a top panel (20), a bottom panel (23), a front panel (21), a back panel (24), side panels (22, 25), **characterized in that** the cosmetic envelope comprises: a top panel (30), a bottom side (33), a front panel (31), a back side (34), side panels (32, 35) such that said envelope surrounds only the top panel (20), the front panel (21), the side panels (22, 25) of the housing element (2), such that the housing element is slidable into the envelope from the back side towards the front panel of the envelope;
- clipping means for being fastened to the housing element, and
- means for being assembled to form a single piece before it is slided onto the housing element.

6. Method for fixing a cosmetic envelope (3) that is constituted of a single piece to a housing element (2) lodging a set of electronic components, the housing element comprising a top panel (20), a bottom panel (23), a front panel (21), a back panel (24), side panels (22, 25), and the envelope (3) comprising a top panel (30), a bottom side (33), a front panel (31), a back side (34), side panels (32, 35) such that said envelope surrounds only the top panel (20), the front panel (21), the side panels (22, 25) of the housing element (2), **characterized in that** it comprises the following steps of:
- sliding the housing element inside the envelope from the back side to the front panel of the envelope;
- clipping on the envelope to the housing element; and
- screwing the envelope to the housing element.

7. Method for removing a cosmetic envelope (3) that is constituted of a single piece from a housing element (2) lodging a set of electronic components, the housing element comprising a top panel (20), a bottom panel (23), a front panel (21), a back panel (24), side panels (22, 25), and the envelope (3) comprising a top panel (30), a bottom side (33), a front panel (31), a back side (34), side panels (32, 35) such that said envelope surrounds only the top panel (20), the front panel (21), the side panels (22, 25) of the housing element (2), **characterized in that** it comprises the following steps of:
- unscrewing the envelope from the housing element;
- unclipping on the envelope from the housing element; and
- sliding the housing element outside the envelope

## Patentansprüche

1. Elektronische Vorrichtung (1), die umfasst:
- ein Gehäuseelement (2) zum Aufnehmen einer Menge elektronischer Bauelemente, wobei das Gehäuseelement (2) eine Deckplatte (20), eine Bodenplatte (23), eine Frontplatte (21), eine Rückplatte (24), Seitenplatten (22, 25) umfasst, und
eine das Gehäuseelement umgebende und an dem Gehäuseelement befestigte Designhülle (3), wobei die Designhülle (3) eine Deckplatte (30), eine Unterseite (33), eine Frontplatte (31), eine Rückseite (34), Seitenplatten (32, 35) umfasst, sodass die Hülle nur die Deckplatte (20), die Frontplatte (21), die Seitenplatten (22, 25) des Gehäuseelements (2) umgibt, sodass das Gehäuseelement von der Rückseite in Richtung der Frontplatte der Hülle in die Hülle geschoben werden kann;
- wobei die Hülle Mittel, um zusammengesetzt zu werden, um ein einzelnes Teil zu bilden, bevor sie auf das Gehäuseelement geschoben wird, und
- Klemmmittel (5, 7, 8, 9), um die Hülle an dem Gehäuseelement zu befestigen, umfasst.

2. Elektronische Vorrichtung nach dem vorhergehenden Anspruch, **dadurch gekennzeichnet, dass** die Klemmmittel umfassen:
- mindestens eine Schlitzanordnung (7) an der Bodenplatte (23) des Gehäuseelements, um mindestens eine Klemme (8) der Hülle anzubringen, und
- mindestens eine Schlitzanordnung (5) an der Deckplatte (20) des Gehäuseelements, um mindestens eine Klemme der Hülle anzubringen.

3. Elektronische Vorrichtung nach einem der vorhergehenden Ansprüche, **dadurch gekennzeichnet, dass** das Gehäuseelement ein Schraubenloch (4) umfasst, dass die Hülle ein Schraubenloch (6) umfasst und dass die Schraubenlöcher einander gegenüberliegen, wenn die Hülle in das Gehäuseelement geklemmt worden ist.

4. Elektronische Vorrichtung nach einem der vorhergehenden Ansprüche, **dadurch gekennzeichnet, dass** sie eine Set-Top-Box ist.

5. Designhülle (3), die ein Gehäuseelement (2) zum Aufnehmen einer Menge elektronischer Bauelemente umgeben soll und an dem Gehäuseelement befestigt werden soll, wobei das Gehäuseelement eine Deckplatte (20), eine Bodenplatte (23), eine Frontplatte (21), eine Rückplatte (24), Seitenplatten (22, 25) umfasst, **dadurch gekennzeichnet, dass** die Designhülle umfasst: eine Deckplatte (30), eine Unterseite (33), eine Frontplatte (31), eine Rückseite (34), Seitenplatten (32, 35), sodass die Hülle nur die Deckplatte (20), die Frontplatte (21), die Seitenplatten (22, 25) des Gehäuseelements (2) umgibt, sodass das Gehäuseelement von der Rückseite in Richtung der Frontplatte der Hülle in die Hülle geschoben werden kann;
- Klemmmittel, um an dem Gehäuseelement befestigt zu werden, und
- Mittel, um zusammengesetzt zu werden, um ein einzelnes Teil zu bilden, bevor sie auf das Gehäuseelement geschoben wird.

6. Verfahren zum Befestigen einer Designhülle (3), die aus einem einzelnen Teil gebildet ist, an einem Gehäuseelement (2), das eine Menge elektronischer Bauelemente aufnimmt, wobei das Gehäuseelement eine Deckplatte (20), eine Bodenplatte (23), eine Frontplatte (21), eine Rückplatte (24), Seitenplatten (22, 25) umfasst und wobei Hülle (3) eine Deckplatte (30), eine Unterseite (33), eine Frontplatte (31), eine Rückseite (34), Seitenplatten (32, 35) umfasst, sodass die Hülle nur die Deckplatte (20), die Frontplatte (21), die Seitenplatten (22, 25) des Gehäuseelements (2) umgibt, **dadurch gekennzeichnet, dass** das Verfahren die folgenden Schritte umfasst:
- Schieben des Gehäuseelements in die Hülle von der Rückseite zur Frontplatte der Hülle;
- Anklemmen der Hülle an das Gehäuseelement; und
- Schrauben der Hülle an das Gehäuseelement.

7. Verfahren zum Entfernen einer Designhülle (3), die aus einem einzelnen Teil gebildet ist, von einem Gehäuseelement (2), das eine Menge elektronischer Bauelemente aufnimmt, wobei das Gehäuseelement eine Deckplatte (20), eine Bodenplatte (23), eine Frontplatte (21), eine Rückplatte (24), Seitenplatten (22, 25) umfasst und wobei die Hülle (3) eine Deckplatte (30), eine Unterseite (33), eine Frontplatte (31), eine Rückseite (34), Seitenplatten (32, 35) umfasst, sodass die Hülle nur die Deckplatte (20), die Frontplatte (21), die Seitenplatten (22, 25) des Gehäuseelements (2) umgibt, **dadurch gekennzeichnet, dass** das Verfahren die folgenden Schritte umfasst:
- Abschrauben der Hülle von dem Gehäuseelement;
- Abklemmen der Hülle von dem Gehäuseelement; und
- Herausschieben des Gehäuseelements aus der Hülle.

## Revendications

1. Dispositif électronique (1) comprenant :
- un élément de boîtier (2) permettant d'héberger un ensemble de composants électroniques, ledit boîtier (2) comprenant un panneau supérieur (20), un panneau inférieur (23), un panneau avant (21), un panneau arrière (24), des panneaux latéraux (22, 25), et
une enveloppe cosmétique (3) entourant ledit élément de boîtier et attaché audit élément de boîtier, ladite enveloppe (3) comprenant un panneau supérieur 30), un côté inférieur (33), un panneau avant (31), un côté arrière (34), des panneaux latéraux (32, 35) de sorte que ladite enveloppe n'entoure que le panneau supérieur (20), le panneau avant (21), les panneaux latéraux (22, 25) de l'élément de boîtier (2), de sorte que l'élément de boîtier peut coulisser dans l'enveloppe à partir du côté arrière vers le panneau avant de l'enveloppe ;
- ladite enveloppe comprenant un moyen pour être assemblée afin de former un seul morceau avant de coulisser dans le boîtier, et
- un moyen de fixation par clips (5, 7, 8, 9) afin d'attacher ladite enveloppe audit élément de boîtier.

2. Dispositif électronique selon la revendication précédente, **caractérisé en ce que** ledit moyen composé de clips de fixation comprend :
- au moins un dispositif de fente (7) sur le panneau inférieur (23) de l'élément de boîtier pour le montage d'au moins un clip (8) de l'enveloppe, et
- au moins un dispositif de fente (5) sur le panneau supérieur (20) de l'élément de boîtier pour le montage d'au moins un clip (8) de l'enveloppe.

3. Dispositif électronique selon l'une quelconque des revendications précédentes, **caractérisé en ce que** le boîtier comprend un trou de vissage (4), l'enveloppe comprend un trou de vissage (6), et lesdits trous de vissage sont face à face lorsque l'enveloppe a été clipsée à l'élément de boîtier.

4. Dispositif électronique selon l'une quelconque des revendications précédentes, **caractérisé en ce qu'**il s'agit d'un boîtier décodeur.

5. Enveloppe cosmétique (3) permettant d'entourer un élément de boîtier (2) pour héberger un ensemble de composants électroniques et à attacher audit élément de boîtier, l'élément de boîtier comprenant un panneau supérieur (20), un panneau inférieur (23), un panneau avant (21), un panneau arrière (24), des panneaux latéraux (22, 25), **caractérisé en ce que** l'enveloppe cosmétique comprend : un panneau supérieur (30), un côté inférieur (33), un panneau avant (31), un côté arrière (34), des panneaux latéraux (32, 35), de sorte que ladite enveloppe entoure uniquement le panneau supérieur (20), le panneau avant (21), les panneaux latéraux (22, 25) de l'élément de boîtier (2), de sorte que l'élément de boîtier coulisse dans l'enveloppe à partir du côté arrière vers le panneau avant de l'enveloppe.
- un moyen composé de clips de fixation pour être attaché à l'élément de boîtier et
- un moyen permettant d'être assemblé afin de former un seul morceau avant de coulisser dans l'élément de boîtier.

6. Procédé permettant d'attacher une enveloppe cosmétique (3) constituée d'un seul morceau à un élément de boîtier (2) hébergeant un ensemble de composants électroniques, l'élément de boîtier comprenant un panneau supérieur (20), un panneau inférieur (23), un panneau avant (21), un panneau arrière (24), des panneaux latéraux (22, 25), et l'enveloppe (3) comprenant un panneau supérieur (30), un côté inférieur (33), un panneau avant (31), un côté arrière (34), des panneaux latéraux (32, 35), de sorte que ladite enveloppe entoure uniquement le panneau supérieur (20), la panneau avant (21), les panneaux latéraux (22, 25) de l'élément de boîtier (2), **caractérisé en ce qu'**il comprend les étapes suivantes :
- coulisser l'élément de boîtier à l'intérieur de l'enveloppe à partir du côté arrière vers le panneau avant de l'enveloppe ;
- clipser l'enveloppe sur l'élément de boîtier ; et
- visser l'enveloppe sur l'élément de boîtier.

7. Procédé permettant de retirer une enveloppe cosmétique (3) constituée d'un seul morceau d'un élément de boîtier (2) hébergeant un ensemble de composants électroniques, l'élément de boîtier comprenant un panneau supérieur (20), un panneau inférieur (23), un panneau avant (21), un panneau arrière (24), des panneaux latéraux (22, 25), et l'enveloppe (3) comprenant un panneau supérieur (30), un côté inférieur (33), un panneau avant (31), un côté arrière (34), des panneaux latéraux (32, 35), de sorte que ladite enveloppe entoure uniquement le panneau supérieur (20), le panneau avant (21), les panneaux latéraux (22, 25) de l'élément de boîtier (2), **caractérisé en ce qu'**il comprend les étapes suivantes :
- dévisser l'enveloppe du boîtier ;
- déclipser l'enveloppe du boîtier ; et
- faire coulisser l'élément de boîtier hors de l'enveloppe.
